## Europäisches Patentamt
## European Patent Office
## Office européen des brevets

(19)

(11) Publication number: **0 065 346**
A2

(12)

# EUROPEAN PATENT APPLICATION

(21) Application number: **82301361.0**

(22) Date of filing: **17.03.82**

(51) Int. Cl.³: **H 01 L 29/74,** H 01 L 27/06, **H 03 K 17/56**

(30) Priority: **20.05.81 US 265606**

(43) Date of publication of application: **24.11.82** Bulletin 82/47

(84) Designated Contracting States: **CH DE FR GB LI SE**

(71) Applicant: **Reliance Electric Company, 29325 Chagrin Blvd., Cieveland, Ohio 44122 (US)**

(72) Inventor: **Baker, Richard H., 26 Wildwood Drive, Bedford Massachusetts (US)**

(74) Representative: **Mitchell, Alan et al, ESSO Engineering (Europe) Ltd. Patents & Licences Apex Tower High Street, New Malden Surrey KT3 4DJ (GB)**

(54) **Semiconductor switching device.**

(57) An integrated circuit semiconductor switching device that can be selectively operated as an SCR 89, 91 or high voltage transistor 91 in one embodiment, includes the circuit equivalent of a PNPN silicon-controlled-rectifier (SCR) 89, 91, an equivalent N-channel field-effect transistor 93 having its channel connected between the base and emitter electrodes of the equivalent PNP transistor 89 of the SCR 89, 91, whereby in one mode of operation, the switching device is operable for turning-on in the manner of an SCR at a time when the field-effect transistor 93 is turned-off, thereafter the field-effect transistor 93 is turned-on for substantially reducing the relative impedance of its channel, thereby shunting current away from the equivalent PNP transistor 89, reducing the forward current gain of the latter to about zero, for permitting the equivalent SCR 89, 91 to be turned-off in the manner of an NPN transistor, via the application of a zero volt or negative signal to the base electrode of its equivalent NPN transistor 91.

The present invention relates generally to power switching circuits and devices, and more specifically to such circuits and devices including the combination of bipolar and field effect transistors on a single integrated circuit substrate.

Silicon-controlled-rectifiers, commonly known as SCR's, are widely applied for use in power switching circuitry, but have the disadvantage that once they are turned-on via a signal applied to their gate electrode, they cannot be turned-off by applying another signal to, or removing the original signal from, their gate electrode. SCR's are turned-off by either substantially reducing towards zero magnitude the current flowing through their main current path, or by reducing to zero value the voltage across their anode and cathode electrodes. Accordingly, in many applications where the voltage across a SCR's anode and cathode electrodes does not "naturally" reduce to zero, complicated circuitry (commutation circuitry) is required to turn-off the SCR.

An advantage of SCR's is the ability of this type of switching device to handle substantially high levels of power. For example, SCR's are available for switching currents from below 0.8 amperes to greater than 4000 amperes, at voltages ranging from below 100 volts to greater than 4000 volts. However, as indicated above, a problem with silicon-controlled-rectifiers is that once they are triggered into conduction the gate loses control of the device. That is, once an SCR is turned-on, changes in the level or polarity of the control voltage at the gate electrode of the SCR cannot be used to switch the device to a non-conductive state. Different attempts have been made in the prior art to modify the basic structure of SCR devices, or to provide auxiliary circuitry around the device, for providing (easy) turn-off control while still maintaining the high power switching capability inherent in an SCR. However, such modified SCR-like devices typically lack the power handling capability and efficiency of a pure SCR device. Basically, an SCR is a four layer PNPN device. The outermost N layer provides a cathode region for the device, the outermost P layer provides an anode region for the device, and typically the inner P region provides a gate or control region that is receptive of a control current for turning-on the device. An example of one attempt in the prior art to modify this basic structure for obtaining turn-off control via the control gate region of the device, is provided by a device structure commonly known as a gate-turn-off switching device (GTO). Although GTO's provide for gate control of both turn-on and turn-off, their power handling capability is substantially lower than that available from a SCR.

The present invention relates, in one aspect, to the discovery of an integrated circuit switching device having substantially the same power handling capability of an SCR, and other known attributes thereof, while providing for turn-off control at the same control electrode used for turn-on, includes in one embodiment NPNPN high power (high V, high I) integrated circuit semi-conductor switching device comprising anode, cathode, base, and gate terminals; an equivalent silicon-control-rectifier including a PNP transistor having emitter and collector electrodes connecting between the anode and base terminals, respectively, and a base electrode, and an NPN transistor having a base electrode connected to the base terminal, and collector and emitter electrodes connected between the base electrode of the PNP transistor and the cathode terminal, respectively; and an equivalent N channel enhancement type field-effect transistor having drain and source electrodes connected between the emitter and base electrodes, respectively, of the equivalent PNP transistor, and a gate electrode connected to the gate terminal; the switching device being operative to a turned-on condition via the concurrent application of an operating voltage to the anode terminal, a positive polarity control signal to the base terminal, and a reference voltage to the cathode terminal, whereby in sequence the equivalent NPN transistor turns-on, causing base current to flow in the equivalent PNP transistor, turning-on the latter, which substantially lowers the impedance of its main current path, permitting current to flow from the anode terminal into the base electrode of the equivalent NPN transistor, completing the turn-on of the switching device and latching the combination of the equivalent NPN and PNP transistors into a conductive state for providing a relatively low impedance current path between the anode and cathode terminals; the switching device being operative from its turned-on condition to a turned-off condition via the application of a positive polarity control signal to the gate terminal for non-linearly turning-on the equivalent N channel field-effect transistor, which substantially lowers the relative impedance between its drain and source electrodes, thereby shunting current away from the emitter electrode of the equivalent PNP transistor to the collector electrode of the equivalent NPN transistor, substantially turning-off the equivalent PNP transistor and unlatching the switching device, making possible use of a zero volt or negative polarity control signal at the base terminal for turning-off the equivalent NPN transistor, completing the turn-off cycle for the device. Also, by maintaining the equivalent N channel FET turned-on, the present device can be operated as an equivalent NPN transistor; or by maintaining the equivalent FET turned-off, the present device can be operated as an SCR; or by operating said FET in its linear region, the holding current for operating said device as an SCR can be controlled within a range.

The present invention will now be described, by way of example, with reference to the accompanying drawings.

In the drawings, wherein like elements are indicated by the same reference designation: Figures 1 and 2 show the equivalent PNP/NPN transistor circuit schematic diagram of a silicon-control-rectifier; Figure 3 shows the carrier flow of a silicon-controlled-rectifier;

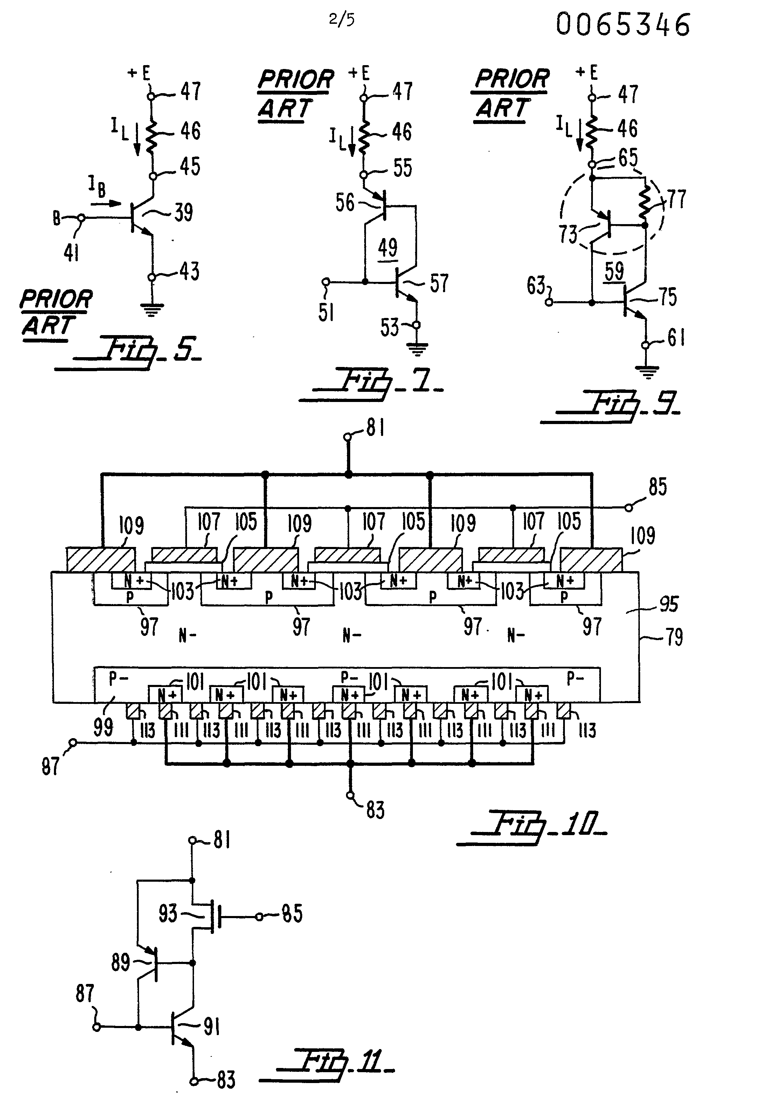

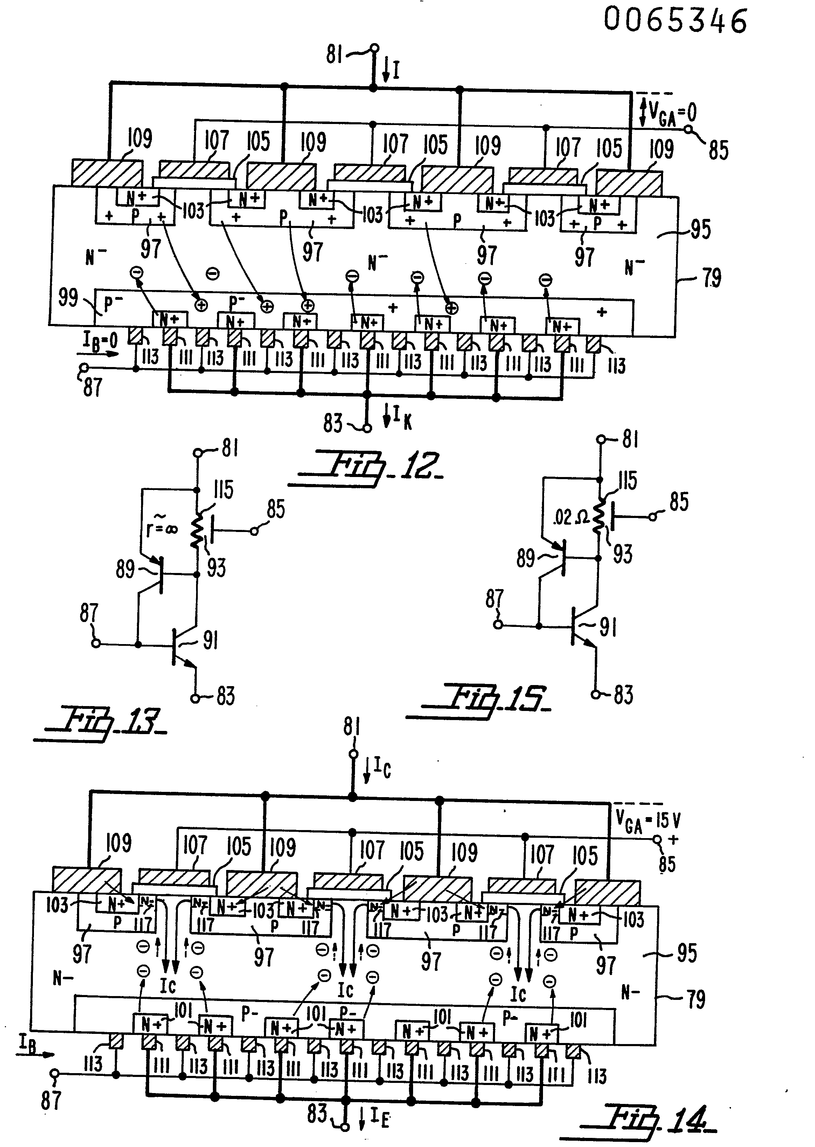

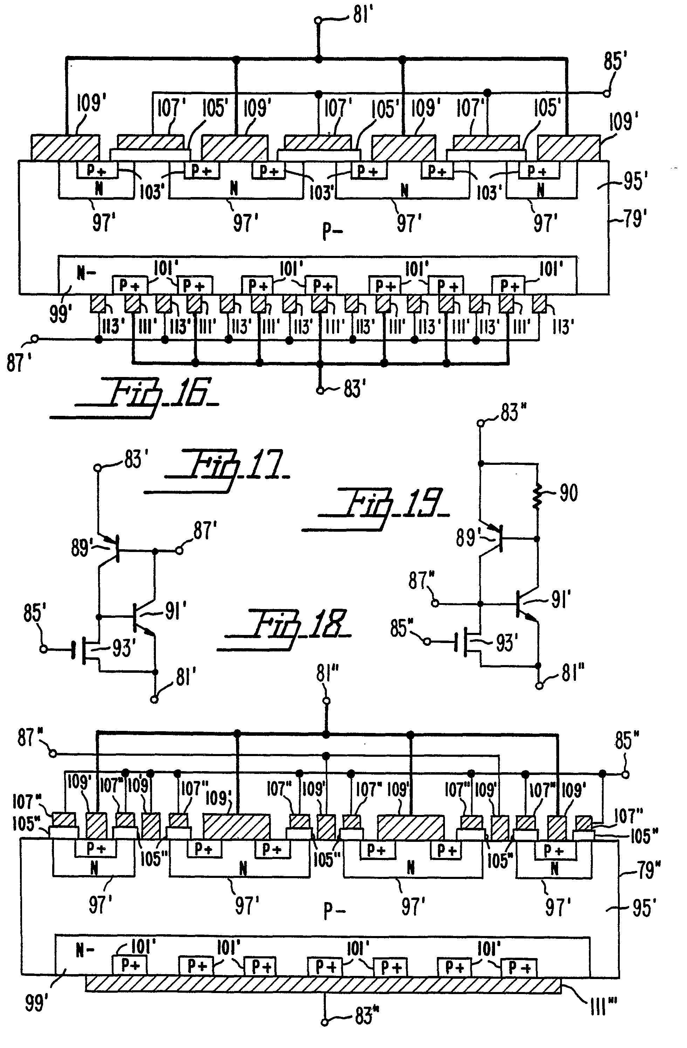

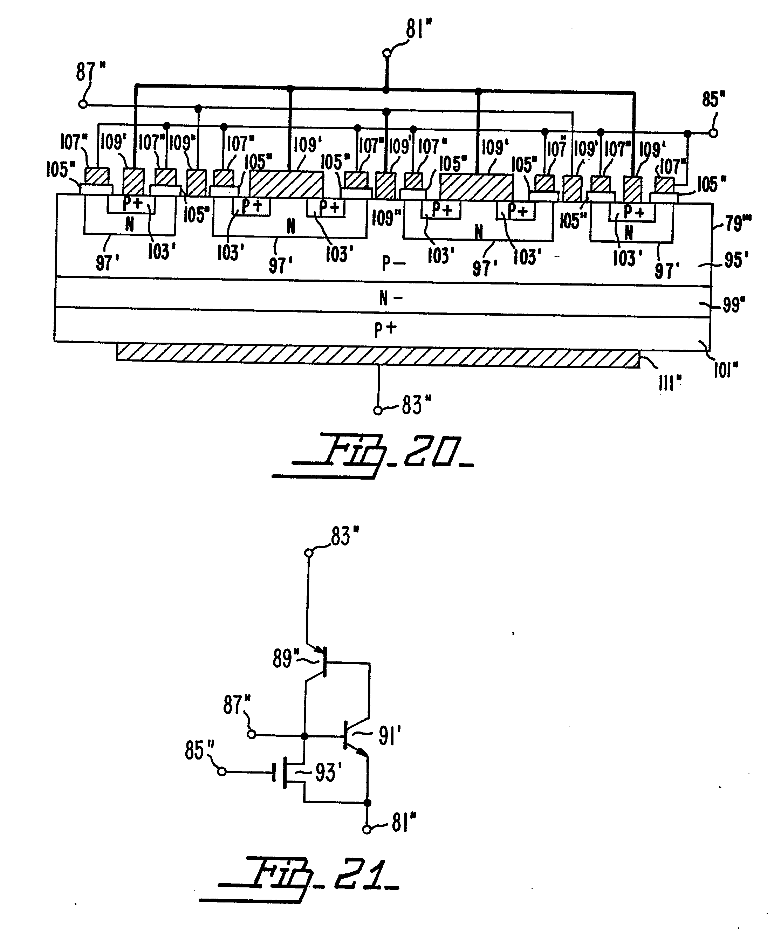

Figure 4 shows a cross-sectional isometric diagram of an idealized prior art NPN bipolar transistor structure; Figure 5 shows a prior art circuit schematic diagram of the NPN transistor of Figure 4 applied for use in driving a load; Figure 6 shows a cross-sectional isometric diagram of an idealized prior art silicon-controlled-rectifier; Figure 7 shows an equivalent circuit schematic diagram of the SCR of Figure 6 applied for use in driving a load; Figure 8 shows a cross-sectional isometric diagram of an idealized prior art gate-turn-off (GTO) thyristor; Figure 9 shows an equivalent circuit schematic diagram of the GTO of Figure 8, applied for use in switching power to a load; Figure 10 shows a cross-sectional diagram of a preferred embodiment of the switching device of the present invention; Figure 11 shows an equivalent circuit schematic diagram of the present switching device of Figure 10; Figure 12 shows a cross-sectional diagram of the present device of Figure 10, indicating the charge flow when the present switching device is operated in the manner of a normal SCR; Figure 13 shows the equivalent circuit schematic diagram of the present switching device when operated in the manner of a normal SCR; Figure 14 shows a cross-sectional diagram of the present switching device of Figure 10, indicating the charge flow therein when the present device is operating in the manner of a typical NPN transistor; Figure 15 shows an equivalent circuit schematic diagram of the present switching device when operated in the manner of a typical NPN transistor; Figures 16, 18 and 20 each show cross-sectional diagrams of alternative embodiments of the switching device of the present invention; and Figures 17, 19 and 21 show equivalent circuit schematic diagram of the switching devices of Figures 16, 18 and 20 respectively.

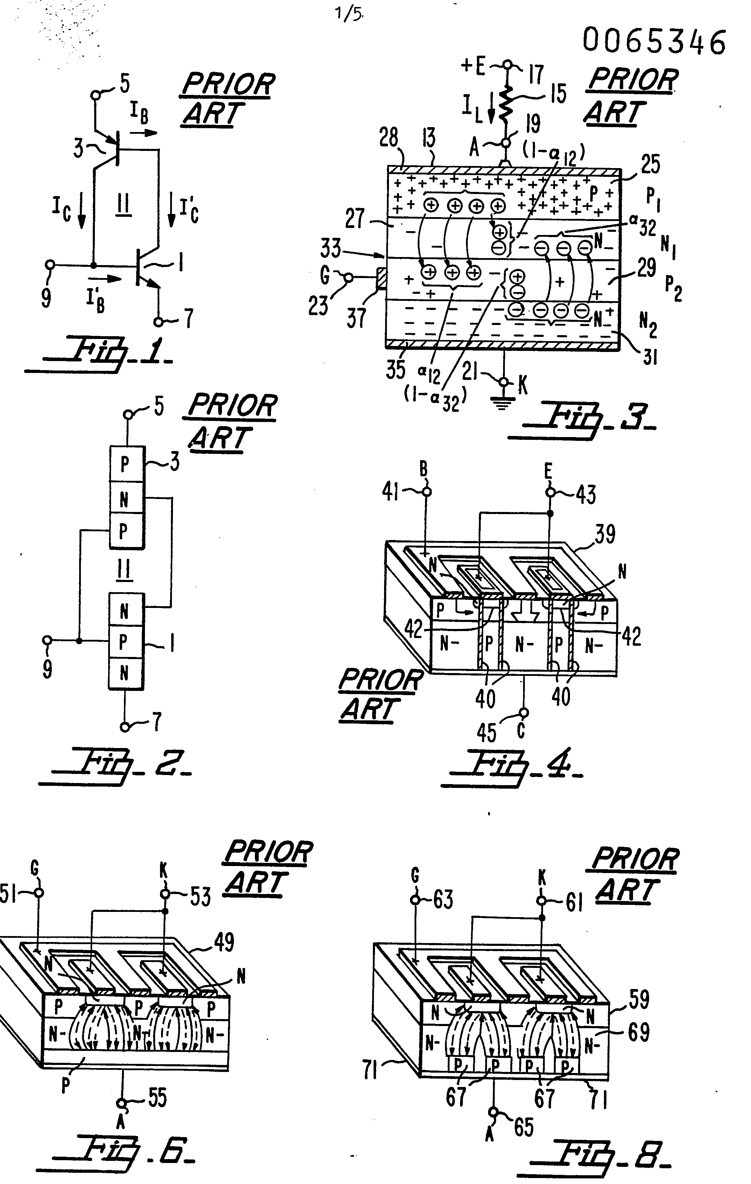

As shown in Figure 1, the conceptual equivalent circuit for an SCR comprises an NPN transistor 1 connected to a PNP transistor 3, to give Postline feedback, as shown. The emitter electrode of the PNP transistor 3 is connected to an anode terminal 5, the emitter electrode of NPN transistor 1 is connected to a cathode terminal 7, and the collector electrode of PNP transistor 3 is connected in common with the base electrode of NPN transistor 1 to a gate terminal 9. Assuming that an operating voltage is connected to the anode terminal 5 of the SCR via a load impedance, (not shown) that a reference potential is connected to the cathode terminal 7, and that a positive polarity control signal is applied to terminal 9 for causing base current $I'_B$ to flow into the base electrode of NPN transistor 1, the turn-on cycle for the SCR device 11 is initiated. Once the $I'_B$ begins to flow in NPN transistor 1, transistor 1 responds by substantially lowering the impedance between its collector and emitter electrodes, in turn causing base current $I_B$ to flow out of the base electrode of PNP transistor 3, this base current providing the collector current $I_C$ for the NPN transistor 1. As soon as the base current $I_B$ begins to flow in transistor 3, this transistor turns-on to substantially lower the relative impedance between its collector and emitter electrodes, thereby providing a low impedance current path for collector current $I_C$ to flow from transistor 3 into the base electrode of NPN transistor 1, thereby generating additional base current flow for the latter, and providing positive feedback or regeneration which causes latching of transistors 1 and 3 into conduction in deep saturation. Another way of representing the bipolar equivalent circuit of an SCR is shown in Figure 2.

In Figure 3, a cross-section of a typical SCR device 13 is shown connected in a circuit for switching power to a load impedance 15. The load 15 is connected between an operating voltage terminal 17 and the anode terminal or electrode 19 of the SCR. The cathode electrode 21 of the SCR is connected to a point of reference potential, ground in this example. The gate terminal 23 is adapted for receiving a positive polarity control signal. As shown, the SCR is typically a four layer (PNPN) device. The top surface of the uppermost P layer 25 has a metal layer 28 deposited thereon for providing the electrical connection to the anode terminal 19. The common junction between the inner N layer 27, and inner P layer 29 is known as an interjunction 33. The outer N layer 31 has a bottom base coated or deposited with a metallic layer 35 for providing an electrical connection to the cathode terminal 21. A metallic layer or coating 37 is deposited on one exposed end of the inner P layer 29 as shown, for providing an electrical connection to the gate terminal 23. In general, when a sufficient level of positive polarity voltage is applied to gate terminal 23, current flows into the P layer 29, causing conductivity modulation to occur within the device, which in turn causes the resistivity of the two center semi-conductor layers 27 and 29 to substantially decrease, causing the SCR device 13 to turn-on for providing a substantially low impedance current path between its anode electrode 19 and cathode electrode 21.

The movement of charge particles through the SCR device 13 when conducting will now be described in detail. Assume that the SCR device 13 has been turned-on as indicated above, and for the sake of simplicity that the magnitude of the load current $I_L$ is equal to a magnitude of one ampere. A hole current (movement of positive or + charges) of magnitude $\alpha_{12}(I_L)$ moves from the $P^+$ layer 25, through the $N^-$ layer 27, and arrives at the $P^-$ layer 29, in substantially the same time that an electron current (movement of negative or - charges) of magnitude $\alpha_{32} I_L$ move from the $N^+$ layer 31, through the $P^-$ layer 29, and arrives at the $N^-$ layer 27. Accordingly, the $P^-$ layer 29 receives a holding current $\alpha_{12}(I_L)$ and an electron current of magnitude $(1-\alpha_{32})I_L$. This causes an accumulation (or depletion depending on relative values of $\alpha_{12}$ and $\alpha_{32}$) of $\oplus$ charges or majority carriers in the $P^-$ layer 29, and (by symmetry) an accumulation of $\ominus$ or majority carriers in the $N^-$ layer 27, at a rate given by equation 1 below:

(1) $\qquad r = [\alpha_{12} - (1-\alpha_{32})]I_L,$

where $\alpha_{12}$ is the proportional number of $\oplus$ charges that survive the transition across both junctions 1 and 2, and $\alpha_{32}$ is the proportional number of $\ominus$ charges that survive the transition across junctions 3 and 2. From equation (1), when $\alpha_{12}$ is substantially greater than $(1-\alpha_{32})$, r is positive and an accumulation of $\ominus$ charge carriers occurs in regions 27 and an accumulation of $\oplus$ charges occurs in regions 29. If $\alpha_{12}$ is substantially less than $(1-\alpha_{32})$, r is negative and a depletion of charge in regions 27 and 29 occurs.

When r is positive, the load current $I_L$ is large, and the P⁻ layer 29 and N⁻ layer 27 are flooded with extra majority carriers. The extra majority carriers causes the N⁻ region 27 and the P⁻ region 29 to become less resistive, giving rise to so called conductivity modulation, thereby permitting the SCR device to pass heavy current with a relatively low voltage drop between the anode and cathode electrodes.

When the SCR 13 is turned-off, that is, when r is negative ($I_L$ being small or substantially equal to zero), the majority carriers are withdrawn (through recombination) from the P⁻ layer 29 and N⁻ layer 27, and a portion of the fixed acceptors and donors in these layers or regions is ionized. This allows a space charge to develop in regions 27 and 29 to allow a potential to develop across junction 33 to oppose the voltage applied at the anode electrode 19. In this condition, the device is off or non-conductive, with a substantially high impedance between its anode and cathode electrodes.

As described above, current flow through an SCR causes an accumulation or depletion of majority carrier charges in the P⁻ and N⁻ layers 29, 27, respectively, at a rate r. If r is positive, the SCR 13 is in the low impedance mode, or turned-on, and if r is negative, the SCR is in a high impedance mode, or turned-off. As is well known, it is possible to turn-off a conducting SCR, that is, to make r go negative, by withdrawing charge at the gate terminal 23. When gate current $I_G$ is withdrawn from terminal 23 (that is, electrons are injected into $P^-$ layer 29), a number of the excess majority carriers, (positive or $\oplus$ charges) are neutralized. If $I_G$ is large enough, such that

$$(2) \qquad I_G > r/\partial_{32}$$

where r is the rate of generation of majority carriers in the $P^-$ region 29, then the regenerative action of the SCR 13 terminates, causing it to turn-off. Substituting the results of equation 2 into equation 1 produces a minimum value of $I_G$ required for gate controlled turn-off of an SCR, as shown in equation 3:

$$(3) \qquad I'_G = \frac{\partial_{12} - (1 - \partial_{32})}{\partial_{32}} I_L$$

where $I'_G$ represents this minimum value of $I_G$ to accomplish gate controlled turn-off. In terms of the turn-off gain (TOG), equation 3 can be expressed as shown in equation 4 below:

$$(4) \qquad TOG = \frac{I_L}{I_g} = \frac{\partial_{32}}{\partial_{12} + \partial_{32} - 1} = \frac{\partial_{npn}}{\partial_{npn} + \partial_{pnp} - 1}$$

where $\partial_{32}$ represents the current gain for the equivalent NPN transistor of the SCR, and $\partial_{12}$ represents the equivalent current gain for the equivalent PNP bipolar transistor of the SCR. Equation 4 indicates that for an SCR structure, the gate control turn-off gain TOG is low, and can only be increased by reducing the value of the current gain of the equivalent PNP transistor, i.e. by reducing the value of $\partial_{pnp}$. This explains why gate turn-off (GTO) devices have low turn-off gain, typically in the range of 3 to 5.

As explained above, an SCR is a conductivity modulated device. This permits the use of thick N and P

layers to be used for the equivalent PNP and NPN transistors of the four layer device, in order to obtain high-voltage and high current capability, in combination with a very low on voltage.

SCR devices have a number of disadvantages. For example, once conducting, an SCR cannot be turned-off by removing the input or drive signal from its gate electrode, or applying a reverse bias signal to the gate electrode. Also, the rate of rise and fall (dv/dt) of the voltage across the anode and cathode terminals must be limited to a predetermined maximum value; and the rate of increase of the current (di/dt) flowing between the anode and cathode electrodes must be limited to some maximum value. The dv/dt rating must not be exceeded because the interjunction capacitances, previously mentioned, can cause false triggering or turn-on of the SCR device. The di/dt is also critical, in that the SCR device is susceptible to destruction from "hot spotting" caused by the di/dt rating of the device being exceeded.

In Figure 4, an idealized structure for an NPN bipolar transistor 39 is shown. The device 39 includes a base terminal 41, an emitter terminal 43, and a collector terminal 45. When the NPN transistor 39 is on, current conduction, due to current crowding, is limited to narrow filaments 40. This current crowding phenomenon and the requirement to maintain a large value for $\alpha_{NPN}$ (to reduce base drive), causes the bipolar structure shown to have a relatively low current and voltage capability per unit silicon area. The equivalent circuit schematic diagram for the device 39 is shown in Figure 5 in a switching circuit for driving a load impedance 46 connected between an operating voltage terminal 47 for receiving an operating voltage of +B volts, and the collector electrode 45 of the NPN transistor 39, with the emitter 43 being connected to a source of reference potential, ground in this example.

In Figure 6, a SCR thyristor device 49 is shown (thyristor being the generic name for a family of devices having similar structures, including SCR's), having a gate electrode 51, a cathode electrode 53, and an anode electrode 55. As previously illustrated for Figure 3, and as shown here, the conductivity modulation phenomenon of the SCR structure 49, when in its conductive state, spreads the current (shown by arrows) more uniformly over a large portion of the semi-conductor substrate area, between the anode and cathode electrodes, than does the bipolar structure of Figure 4. A schematic equivalent circuit diagram of the SCR device 49 is shown in circuit form for switching power to a load impedance 46 connected between the anode electrode 55 and the operating voltage terminal 47, with the cathode electrode 53 being connected to a source of reference potential, ground in this example. The gate electrode 51 is receptive of a positive polarity control signal, as previously indicated, for turning-on the SCR device 49. It is preferred, as indicated in Figure 7, to make the $\alpha$ PNP or forward-current transfer ratio for the equivalent PNP transistor 56 of a higher value relative to the NPN current gain for the equivalent NPN transistor 57, in order to reduce the problem of false triggering, typically caused by voltage transients, or large savings of voltage between the anode and cathode electrodes.

In Figure 8, an idealized cross-section for another thyristor device, known as a gate-turn-off (GTO) thyristor 59 is shown. The GTO 59 has a cathode electrode 61, a gate electrode 63, and an anode electrode 65. Note that its structure is similar to that of the structure of the SCR of Figure 6, except that the P-type conductivity anode region 67 is distributed into a plurality of individual sections 67 separated by portions of the $N^-$ substrate 69, with a metallized layer 71 overlying the bottom face of the substrate 69 for electrically connecting the substrate 69 and region 67 to form an anode electrode 65. The current flow in the GTO device 59, shown by the arrows, is similar to the distribution of the current flow in the SCR device 49 of Figure 6.

The equivalent circuit schematic diagram for the GTO device 59 is shown in Figure 9 to include a PNP equivalent transistor 73, an NPN equivalent transistor 75, and an equivalent resistor 77 connected between the base and emitter electrodes of the PNP transistor 73. In the GTO device 59, because the substrate or $N^-$ region is shown lightly doped, the substrate region 69 has a relatively high resistivity, and the $N^-$ regions between the anode P sections gives rise to an equivalent resistance 77 between the emitter and base electrodes of the equivalent PNP transistor 73 (see circuitry within broken circle). The equivalent resistance 77 effectively causes the $\alpha_{pnp}$ current gain of the effective PNP transistor 73 to be lower than that of the equivalent PNP transistor 55 of the SCR device 49. In order to compensate for the lower value of $\alpha_{PNP}$ the $\alpha_{NPN}$ for the GTO device must be higher. Accordingly, the maximum voltage rating of GTO's are typically lower than the voltage ratings for SCR's, and the GTO devices have lower maximum values of dv/dt. However, as desired, the turn-off gain of the GTO device 59 is substantially higher than the turn-off gain of the SCR device 49, permitting the GTO device 59 to be turned-off by appropriate signaling at its gate electrode 63.

The primary problem with thyristor or SCR-like devices (the GTO) is that they are typically difficult to turn-off; SCR's cannot be turned-off via signaling at their gate electrodes, and GTO's have only partial turn-off capability at their gate electrodes, that is, the turn-off gain of a typical GTO is relatively low valued, typically between 3 and 5. Also, to turn-off a GTO requires heavy snubbing, that is, added circuitry for protecting the devices against excess power dissipation during turning-off under conditions of high voltage and high current and for protecting from false triggering. It is known that these problems can be reduced by increasing the turn-off gain of the devices. However, the value of the bypass resistor 77 for the equivalent PNP transistor 73 of the GTO device or structure 59 is a compromise; if this value is too large, the turn-off gain is low, if it is made too small, then normal SCR-like action is impaired. Recognizing this, the present inventor discovered than an SCR-like device, including active means for selectively providing a relatively large value of resistance between the emitter and base electrodes of the equivalent PNP transitor 55, would permit the $\alpha_{PNP}$ to be large (approximately 1) for providing normal SCR-like action during turn-on and times of current conduction, whereby the active means is responsive to a control signal for reducing the value of this resistance to a relatively low value for reducing the $\alpha_{PNP}$ to near zero, for providing a high gain for the switching the device to an off condition.

In Figure 10, a cross-section of one embodiment of the present switching device 79 is shown to include four terminals, an anode terminal 81, a cathode terminal 83, a gate terminal 85, and a base terminal 87 (these terminals may also be viewed as electrodes of the device). In Figure 11, a schematic diagram for the equivalent circuit of the device of Figure 10 is shown to include a PNP transistor 89, an NPN transistor 91, and an N channel enhancement field effect transistor 93. The device 79 includes a substrate 95 having an N type conductivity, in this example. Regions of different conductivity types are provided in the substrate 95 by known techniques, such as diffusion, and will be described in detail as follows. The equivalent PNP transistor includes the P regions 97 providing in combination an interdigitated emitter region, the substrate 95 providing a base region, and the P conductivity region 99 providing a collector region. The equivalent NPN transistor 91 includes N type conductivity regions 101 providing interdigitated emitter regions, the P region 99 providing the base region, and the substrate 95 providing the collector region. The equivalent N-channel field effect transistor is an enhancement type device, including the N conductivity regions 103 providing an interdigitated drain region, a plurality of electrically insulated thin film coatings 105 (typically comprising silicon dioxide) are deposited on the top face of the substrate 95 as shown, and each insulative portion 105 is coated with a metallization layer 107, the combination providing an interdigitated gate, the substrate 95 providing the source region, and the portions of the P-type conductivity region 97 under the interdigitated gates 105 and 107 providing the channel regions. The level of doping for each one of the regions of the device 79 is shown in Figure 10, wherein it is preferred that the substrate 95 be of relatively low $N^-$ -type conductivity, the semi-conductor regions 99 be of relatively low $P^-$ -type conductivity, and the semiconductor regions 101 and 103 be of relatively high $N^+$ -type conductivity. Accordingly, the preferred embodiment of the present switching device 79 includes equivalent transistors 89, 91 and 93 merged into a common substrate 79 in an interdigitated fashion. Areas of metallization 109 are deposited upon the top face of the substrate 95 and connected in common to terminal 81 for providing an anode electrode or terminal of the device 79, areas of metallization 111 are deposited on the bottom face of the substrate over the regions 101 and connected in common to terminal 83 for providing the cathode electrode or terminal of the device, and other areas of metallization 113 are deposited upon portions of the bottom surface of the substrate 95 over different portions of the semi-conductor region 99, and connected in common to terminal 87 for providing the base electrode or terminal of the device 79.

The switching device 79 is operable in several different modes; first in the manner of a typical SCR for purposes of turn-on, and during the predominant time of its conduction period, for example, via the application of a zero volt gate signal ($V_{GA}$ = 0 volt) to gate terminal 85 (the gate could also be left open to accomplish the same result) for causing the low voltage field-effect transistor 93 to be turned-off or non-conductive, applying an operating voltage of +E volts to the anode terminal 81 via a load impedance, for example, and connecting the cathode terminal 83 to a source of reference potential, and thereafter applying a positive polarity control signal of sufficient level to the base terminal 87 for causing the device 79 to turn-on in the manner of an SCR. Figure 12 shows the charge current flow of the device 79 when operating as a typical SCR, and Figure 13 shows the equivalent circuit schematic diagram for the device 79 when so operated. Note that positive charges flow from the P-type conductivity semi-conductor regions 97, through the substrate 95, to the $P^-$ semi-conductor region 99, and negative charge flows from the interdigitated $N^+$ -type conductivity semi-conductor region 101 into the substrate semi-conductor region 95. This charge current flow causes the relative impedance between the anode terminal 81 and cathode terminal 83 to be substantially reduced, resulting in an anode current flow $I_A$, and cathode current flow $I_K$, as shown. From Figure 13, note that the impedance of the channel 115 of the field-effect tansistor 93 has a substantially high impedance (r is equal to approximately infinity, in the ideal case), making the equivalent circuit diagram under these conditions substantially that of a typical SCR device.

Second, turn-off of device 79 is easily accomplished by changing the voltage between the gate terminal 85 and anode terminal 81 to +15 volts (for example) relative to the gate electrode 85, for forming $N^-$ channels 117 (see Figure 14) within the semi-conductor regions 97, for conducting current or charge flow around the interdigitated PNP emitterbase interface 97 to the substrate 95 via current flow from the interdigitated anode electrodes 109, through the interdigitated drain regions 103, to their respective channels 117, to the substrate semi-conductor regions 95. The charge flow under these conditions is shown in Figure 14, and the equivalent circuit schematic diagram for the device 79 operating under these conditions is shown in Figure 15, wherein as illustrated the channel for the field-effect transistor 93 has a relative low impedance of about 0.02 ohms (when operated non-linearly as in this example), thereby substantially shorting the base and emitter electrodes of PNP transistor 89, causing its $\alpha_{PNP}$ gain to be reduced to about zero. Accordingly, in this condition of conduction, the device 79 is operating substantially as a typical NPN transistor, the transistor 91 representing the equivalent NPN transistor. To turn the device 79 off from this condition of operation is directly analogous to turning-off an NPN transistor, that is, an open circuit or a zero volt or negative polarity signal may be applied between the base terminal 87 for turning-off the equivalent NPN transistor 91, thereby turning-off the device 79. When a zero volt or negative polarity control signal is applied to the base terminal 87, charges are drawn out of the semi-conductor region 99 to the base terminal 87, and the PN junction between the semi-conductor regions 99 and 101 are back biased, causing a cessation in current flow through the device 79, thereby turning it off. In other words, another way of viewing the turn-off for the device 79, is that with the equivalent field-effect transistor 93 fully turned-on the edge areas of the P-type conductivity interdigitated anode regions 97 are converted from a P to a $N^-$ polarity, and current flow is from the anode terminal 81, through the metallization areas 109, the $N^+$ interdigitated regions 103, the regions 117, directly to the $N^-$ substrate 95 now substantially providing only a collector region for the equivalent NPN transistor 91. Accordingly, charge flow thereby bypasses the P-type injection mechanism of the PNP equivalent emitter regions 97 via the low resistivity paths provided by the channels 117. These low resistivity paths 117 effectively cut off the P-type conductivity interdigitated emitters 97, and prevent hole or $\oplus$ charge injection from the emitters of the equivalent PNP transistor 89. Accordingly, as previously mentioned, the present device 79 operating with a positive gate signal relative to the anode functions as an ordinary NPN transistor, which can easily be turned off via the application of a zero volt or negative polarity control signal to the base terminal 87. Also, as shown in Figure 14, when operating in this condition, the current flowing from anode terminal 81 into the device 79 can be viewed as collector current $I_C$ of the equivalent NPN transistor 91, and the current flowing to the cathode electrode 83 can be viewed as emitter current $I_E$ of the same equivalent NPN transistor 91.

As shown above, the present switching device 79 is a five-layer, four-terminal device that can be selectively operated as either a bipolar transistor or as a SCR, depending upon the voltage $V_{GA}$ applied between the gate and anode terminals 85, 81, respectively. When the device 79 is initially turned-off or non-conductive, if a positve polarity voltage $V_{GA}$ with respect to the gate terminal 85 of about +15 volts is applied to the device 79, the equivalent circuit of the device is that of an NPN transistor in its non-conductive or turned-off condition. Alternatively, when the voltage $V_{GA}$ is equal to zero volt, the device 79 is configured as a typical SCR, and can be rapidly triggered to the conductive or "on" condition by applying a pulse of current into its face terminal 87. When turned-on as an SCR, the present device 79 is capable of handling large currents with a correspondingly low voltage drop between its anode terminal 81 and cathode terminal 83 via majority carrier flow in its corresponding base regions 95 and 99, which gives rise to conductivity modulation as in a typical SCR. However, unlike an SCR, when the present switching device is so turned-on and functioning as an SCR, it can easily be turned-off by changing the value of $V_{GA}$ from zero volt to about +15 volts, for example, causing the device 79 to either turn-off if zero volt or a negative voltage is at that time being applied to the base terminal 87, or to operate substantially as a low gain NPN transistor if at the time of changing the gate voltage a positive polarity signal is being applied to the base electrode 87.

Accordingly, viewing the device 79 from its equivalent circuit of Figure 11, and the above discussion, it can be turned-on and off as a bipolar transistor, operated in the continuous mode as an SCR or a transistor, and if desired selectively turned-on or turned-off as an SCR in the alternative. The present switching device 79 offers substantial improvements and advantages not previously available in the prior art thyristor devices such as elimination of the requirement for commutation circuitry for turning-off the device, the provision of high di/dt and dv/dt capability consistent with bipolar transistor action, substantially reduced susceptibility to false triggering problems when in its non-conductive state with the voltage at the base terminal 87 being held at zero volt or some negative value, and the voltage at the gate terminal 85 being at a sufficiently high positive level for turning-on the equivalent field-effect transitor 93, and when operated as an SCR provides a high-input impedance field controlled semi-conductor device that latches into the conductive state for providing self-supplied drive in the manner of an SCR. Heretofore, such operational characteristics are unavailable in any known switching device that has come to the attention of the present inventor.

The various doping levels and conductivity types of the different regions of the present device 79 have been herein illustrated for the purposes of showing a preferred embodiment of the invention, but are not meant to be limiting. For example, the doping levels of the various regions may be altered to obtain desired operating characteristics for the device and the conductivity types of the various regions can be reversed, in concert with reversing the operating voltage levels and current and charge flow directions, and yet remain within the spirit and embodiments of the present invention. Also, by operating the equivalent FET 93 in its linear mode, the device 79 can be operated as an SCR having a holding current magnitude selectively variable within a range via control of the level of voltage applied the gate electrode of FET 93.

As mentioned above, the device of Figure 10 can be provided in an alternative embodiment by reversing the conductivity types of the various regions, as shown in Figure 16. In Figure 16, all of the reference numbers have been primed to distinguish from Figure 10 but facilitate easy comparison between the two embodiments. Figure 17 shows the equivalent circuit schematic diagram for the device 79' of Figure 16. In comparing the circuits of Figures 11 and 17, the base connection 87 of Figure 11 is to the NPN transistor 91, whereas the base connection 87' of Figure 17 is to PNP transistor 89'; and the N-channel field-effect transistor 93 of Figure 11 has its channel connected across the base-emitter junction of PNP transistor 89, and has a central terminal 85, whereas the P-channel field-effect transistor 93' of Figure 17 has its channel connected across the base-emitter junctions of NPN transistor 91', and has a control terminal 85'. Also, in Figure 11, the anode of the device of Figure 10 terminates at terminal 81, and the cathode at terminal 83; whereas Figure 17, for the device of Figure 16, its anode terminates at terminal 83', and cathode at terminal 81'.

The equivalent field-effect transistor 93' is a P-channel enhancement type device including the P-conductivity regions 103' providing an interdigitated drain region, a source region being provided by the substrate 95', and the portions of the N-type conductivity regions 97' under the interdigitated gates 105', 107' providing the channel regions. A negative polarity control signal applied to terminal 85' turns on transistor 93'. The equivalent PNP transistor 89' includes interdigitated emitter regions 101', base region 99', and collector region 95. The equivalent NPN transistor 91' includes collector region 99', base region 95' and interdigitated emitter regions 97'.

With reference to Figure 17, the device 79' of Figure 16 is operable as an SCR-like device by maintaining FET 93' turned-off, and turning on the equivalent PNP transistor 89', causing the impedance between its emitter and collector electrodes to substantially reduce, permitting base current to flow in NPN transistor 91' turning the latter on, latching the device 79' into the conductive state. The device can be turned-off by reducing to about zero the magnitude of the current flowing between the anode 83' and cathode 81' electrodes, as with any SCR-like device. Alternatively, just before the device is to be turned-off, FET 93' can be turned-on to substantially lower the gain of NPN transistor 91', permitting the device to continue conducting effectively as a PNP transistor 89', whereby turn-off of the device is completed by applying a positive polarity control signal to base terminal 87' for turning-off PNP transistor 89'. Accordingly, the device of Figure 16 can be selectively operated as an SCR, or as a PNP transistor. Alternatively, as previously discussed, the device of Figure 10 is selectively operable as an SCR or as an NPN transistor.

In Figure 18, an alternative embodiment 79" of the device 79' of Figure 16 is shown. The differences between the two are that in Figure 16 base electrode 87' is provided by electrodes (metallization) 113' deposited over different portions of the base region 99' of PNP transistor 89', whereas in Figure 18 base electrode 87" is provided by separate metallizations 109" deposited over different portions of the base region 95' for NPN transistor 91'. In Figure 16, the emitter electrode 83' (anode of device) is provided by metallization to each one of the interdigitated emitter regions 101', whereas in Figure 18, a single metallization layer 111 overlying the interdigitated emitter regions 101' and base region 99', of PNP transistor 89' provides the emitter electrode or terminal 83", and metallization 111 also provides a relatively low value resistor 90 (typically 0.5 ohm to 1.0 ohm) for shunting the areas 101' and 99' (as shown in Figure 19, resistor 90 is connected between the emitter and base electrodes of PNP transistor 89'); in Figure 16

the interdigitated gate electrode 85' is provided by silicon dioxide layers 105' with overlying metallization 107', the combination overlying N regions 97' and portions of the top face of substrate 95' therebetween, whereas in Figure 18, the interdigitated gate electrode 85" is provided by insulating layers 105" upon which metallization 107" is deposited, the combination overlying individual portions of N regions 97'; and in Figure 16, the anode electrode 81' is provided by four individual metallizations 109' overlying portions of N regions 97' and P+ regions 103', whereas in Figure 18, the anode electrode 81" includes only two metallizations 109'.

Operation of the device 79" of Figure 18, with reference to its equivalent circuit schematic diagram of Figure 19, will now be described. The device 79" is turned on in the manner of an SCR by applying a positive level pulse-like control signal to base terminal 87", while FET 93' is turned-off, thereby causing transistor 91' to turn-on, in turn providing base current flow in transistor 89', causing it to turn-on for completing the turn-on cycle. The device 79" can be turned-off in the manner of an SCR by reducing to about zero the magnitude of the current flowing between anode 83", terminal 83" and cathode terminal 81". Alternatively, just before it is desired to turn-off device 79", FET 93' is turned-on by applying a control voltage having a negative polarity to terminal 85", for diverting base current away from transistor 91, causing it to come out of saturation. If the gain of PNP transistor 89' has been substantially reduced by the shunting effect of resistor 90, device 79" will turn-off upon turn-on of FET 93'. However, if the gain of PNP transistor 89' is sufficently high, device 79" will continue conducting, until a negative pulse of sufficient amplitude and duration is applied to terminal 87".

The present device 79, and alternative embodiments 79', 79", shown in Figures 10, 16 and 18 respectively, all have asymmetrical configurations. In Figure 20, a third alternative embodiment 79"' of the present device is shown in a symmetrical configuration. This third alternative embodiment 79"' differs from the embodiment of Figure 18, in that the interdigitated emitter electrodes 101' of 79" have been eliminated in 79''' by providing a single equivalent emitter region 101" for the equivalent PNP transistor 89" (see Figure 21 for the equivalent circuit schematic diagram of device 79'''). Also, the emitter region 101" is underlying a unified layer or region 99" providing a base region for equivalent PNP transistor 89", and a collector region for equivalent NPN transistor 91'. As shown in Figure 21, the equivalent resistor 90 of device embodiment 79" is eliminated in the embodiment for device 79''', because in 79''' the interdigitated emitter regions 101' have been eliminated. Accordingly, in general, the gain of device 79''' of Figure 20 will be greater than the gain of device 79" of Figure 18. Operation of the device 79''' of Figure 20 is substantially the same as device 79" of Figure 18, except that completion of turn-off of the device of Figure 20 will normally require the application of a negative pulse to terminal 87" after FET 93' has been turned-on.

If the conductivities of device 79''' of Figure 20 are reversed, the resulting device will be the symmetrical equivalent of the embodiment of the invention shown in Figure 10. In general, the symmetrical configurations for the various alternative embodiments of the present switching device are the simplest, and therefore, least expensive to produce. Another advantage of the symmetrical configuration is that such a device can block very high reverse voltages across its anode and cathode electrodes in both directions, whereas an asymmetrical configuration can only block high voltages in one direction.

Further simplification of the present device configurations of Figures 18 and 20 is possible by eliminating the extreme right-hand and left-hand regions 97' and 103', and their associated metallizations 109', 107", and thin film insulating layers 105". Even further simplification is obtained by eliminating all but one of the regions 97', whereby the device would include one of the central regions 97', its associated two regions 103', metallization 109', 107", and thin film insulators 105", in combination with one or two base pad metallizations 109". All other areas of the device of Figure 20 would remain as shown, but in the embodiment of Figure 18, the number of interdigitated emitter regions 101' can also be reduced. Such simplification reduces production costs, but from a theoretically viewpoint, also reduces the performance of the device. Alternatively, performance of the device can be increased by increasing the number of interdigitated regions. Similar comments can be made for the alternative device embodiments of Figures 10 and 16.

Although in the illustrated and described embodiments of the invention the FET 93,93' selectively provides a high or low resistance shunt path across the P- or N-type region connected to the anode terminal of the semiconductor switching device, it will be readily apparent that other embodiments are possible in which either a PNPN or NPNP semiconductor device has its shunt FET connected instead across the P- or N-type region connected to the cathode terminal, and also one of the P- and N-type regions, which is common to the interconnected PNP and NPN transistors constituted by the P- and N-type regions of the semiconductor device, connected to the base terminal.

## CLAIMS

A semiconductor switching device, characterised in that it comprises cathode, anode and base electrodes (83, 81, 87); P- and N-type regions (95, 97, 99, 101) which collectively provide a PNP transistor means (89) and an NPN transistor means (91), a P-type region (99) and an N-type region (95) of the PNP transistor means (89) being in connection, respectively, with a P-type region (99) and an N-type region (95) of the NPN transistor means (91), one of the P- or N-type region pairs (95:99) being in connection with said base electrode (87), and the third regions (101, 97) of the two transistor means (89, 91) being respectively in connection with said cathode and anode electrodes (83, 81); and resistive switching means (93) operable for providing a shunt path of low or high resistance, selectively across one said region (97, 101) which is in connection with said anode or cathode electrode (81, 83), so that the PNP and NPN transistor means pairs (89, 91) can be operated substantially as a silicon controlled rectifier or a single transistor according to whether the switching means (93) provides the high or low resistance shunt path, respectively.

A semiconductor switching device according to claim 1, characterised in that said resistive switching means comprises a field-effect transistor means (93).

A semiconductor switching device according to claim 2, characterised in that it comprises a single semiconductor component, consisting of P- and N-type regions, which provides the PNP and NPN transistor means (89, 91) and the field-effect transistor means (93).

4.      A dual-mode interdigitated semiconductor switching device characterised in that it comprises

a semiconductor substrate (95) of a first conductivity type having a top face and a bottom face;

first   to    fourth semiconductor regions (97) of a second conductivity type successively juxtaposed upon and extending into the top face of said substrate;

fifth and sixth semiconductor regions (103) of said first conductivity type wholly within and extending into said first and fourth semiconductor regions from the top face of said substrate, respectively;

seventh and eighth individual semiconductor regions (103) of said first conductivity type wholly within and extending into said second semiconductor region;

ninth and tenth individual semiconductor regions (103) of said first conductivity type wholly within and extending into said third semiconductor region;

an eleventh semiconductor region (99) of said second conductivity type wholly within and extending into the bottom face of said substrate;

a plurality of twelfth individual semiconductor regions (101) of said first conductivity type wholly within and extending into said eleventh semiconductor region from the bottom face of said substrate;

a plurality of electrically insulative thin film coatings (105) individually overlying the top face of said substrate at least between the nearest boundaries of said fifth and seventh semiconductor regions, said eighth and ninth semiconductor regions, and sixth and tenth semiconductor regions, respectively;

first electrically conductive means (107) overlying each one of said plurality of electrically insulative thin film coatings, respectively, for electrically interconnecting these coatings and providing an interdigitated gate electrode;

second electrically conductive means (109) overlying portions of said substrate and first and fifth semiconductor regions, said second, seventh and eighth semiconductor regions, said third, ninth and tenth semiconductor regions, and said substrate and fourth and sixth semiconductor regions, respectively for electrically interconnecting these regions and providing a first interdigitated electrode;

third electrically conductive means (111) overlying portions of said plurality of twelfth individual semiconductor regions, for electrically interconnecting these twelfth regions and providing a second interdigitated electrode;

fourth electrically conductive means (113) overlying portions of the bottom face of said substrate on either side of each one of said plurality of twelfth individual semiconductor regions, for providing an interdigitated base electrode;

whereby in response to a voltage bias of one polarity relative to said second electrode being applied to said base electrode, concurrent with either one of no voltage bias, or a voltage bias of zero volt or opposite polarity to said one polarity being applied to said gate electrode, a low impedance current path forms through said first semiconductor region, and said substrate, permitting current flow therebetween, in turn causing the impedance between said first region, said substrate, and said eleventh region to rapidly decrease permitting current flow therebetween, in turn causing the impedance between said substrate, and said eleventh and twelfth semiconductor regions to rapidly decrease, the above-mentioned responses being regenerative, thereby permitting a relatively high magnitude of current flow between said first and second electrodes, and causing operation of said device in a latched condition, wherein changes in the voltage at said base electrode are not effective for turning off said device.

Whereby in response to a voltage bias of said one polarity and above a given level being applied to said gate electrode, low impedance current paths, or channels form between said fifth and first regions and said substrate, said second and seventh regions and said substrate, said second and eighth regions and said substrate, said third and ninth regions and said substrate, said third and tenth regions and said substrate, and said fourth and sixth regions and said substrate, permitting current to flow therethrough, thereby causing a substantial reduction in the magnitude of current flow in said first through fourth regions, thereby substantially eliminating said regenerative effect in said device, causing said device to now operate substantially in an unlatched condition, responsive to a zero volt or bias of said opposite polarity being applied to said base electrode, for substantially increasing the impedance between said substrate, eleventh and twelfth regions, causing a cessation in the flow of current in said device, thereby turning off said device;

said device also being responsive to the magnitude of current between said first and second electrodes reducing to below a "holding current magnitude" for turning-off from its latched condition, said holding current magnitude being controllable within a range via control below said given level of the level of said voltage bias applied to said gate electrode.

5. A switching device according to claim 1, characterised in that said semiconductor substrate consists of N-conductivity type material, whereby said first and second interdigitated electrodes provide anode and cathode electrodes, respectively.

6. A switching device according to claim 1, characterised in that said semiconductor substrate consists of lightly doped N⁻ conductivity type material, said first through fourth semiconductor regions each consists of P conductivity type material, said fifth through tenth and twelfth semiconductor regions each consist of heavily doped N$^+$ conductivity type material, and said eleventh semiconductor region consists of lightly doped P$^-$ type conductivity material, whereby said first and second interdigitated electrodes provide anode and cathode electrodes, respectively.

7. A switching device according to claim 1, characterised in that said semiconductor substrate consists of N-conductivity type material, whereby said first and second interdigitated electrodes provide cathode and anode electrodes, respectively.

8. A switching device according to claim 1, characterised in that said semiconductor substrate consists of lightly doped P$^-$ conductivity type material, said first through fourth semiconductor regions each consists of N conductivity type material, said fifth through tenth and twelfth semiconductor regions each consist of heavily doped P$^+$ conductivity type material, and said eleventh semiconductor region consists of lightly doped N$^-$ type conductivity material, whereby said first and second interdigitated electrodes provide cathode and anode electrodes, respectively.

9. An integrated circuit switching device, characterised in that it comprises:

First to fourth terminals (81, 85, 87, 83) for receiving an operating voltage, a first control signal, a second control signal, and a source of reference potential, respectively;

a PNP transistor (89) having an emitter electrode connected to said first terminal, a collector electrode connected to said second terminal, and a base electrode;

an NPN transistor (91) having a base electrode connected to said second terminal, a collector electrode connected to the base electrode of said PNP transistor, and an emitter electrode connected to said fourth terminal; and

shunting means (93) having a main current path connected between the base and emitter electrodes of said PNP transistor, and a control electrode connected to said third terminal;

said device being responsive to the concurrence of said second control signal having a first level of voltage, for ensuring said shunting means is in a turned-off condition, with its main current path having a relatively high impedance, and said first control signal having a positive level of voltage, for turning on said NPN and PNP transistors, and thereby operating said device substantially as a silicon-controlled rectifier.

said shunting means being responsive to said second control signal having a second level of voltage, for turning-on to substantially lower the impedance of its main current path, thereby shunting current away from said emitter electrode, through its main current path to the collector electrode of said NPN transistor, causing the forward current transfer ratio of said PNP transistor to reduce to substantially zero, substantially turning-off said PNP transistor, permitting said device to now operate substantially as an NPN transistor, thereby permitting said device to be turned-off by changing the level of said first control signal to either one of a zero volt or negative voltage level, causing said NPN transistor to turn off, said device being operable as an NPN transistor for turning-on whenever said second control signal is at its second level of voltage;

said shunting means also being responsive within a range to said second control signal having a level between said first and second levels, for establishing the holding current magnitude for said device when operating as a silicon-controlled-rectifier.

10. A switching device according to claim 6, characterised in that said shunting means consists of an N-channel field effect-transistor (93) having drain and source electrodes connected between the emitter and base electrodes, respectively, of said PNP transistor, and a gate electrode as said control electrode, whereby said field effect transistor is responsive to said second control signal having a positive level of voltage, for turning-on;

11. An integrated circuit semiconductor switching device, characterised in that it comprises:
first to fourth terminals (81, 87, 85, 83);
a silicon-controlled-rectifier including a PNP transistor (89) having emitter and collector electrodes connected between said first and second terminals, respectively, and a base electrode, and an NPN transistor (91) having a base electrode connected to said second terminal, and collector and emitter electrodes connected between the base electrode of said PNP transistor and said fourth terminal, respectively; and
an N channel field-effect transistor (93) having drain and source electrodes connected between the emitter and base electrodes, respectively, of said PNP transistor, and a gate electrode connected to said third terminal;
said switching device being operative to a turned-on condition via the concurrent application of an operating voltage to said first terminal, a positive polarity control signal to said second terminal, and a reference voltage to said fourth terminal, whereby in sequence said NPN transistor turns-on, causing base current to flow in said PNP transistor, turning-on the latter, which substantially lowers the impedance of its main current path, permitting current to flow from said first terminal into the base electrode of said NPN transistor, completing the turn-on of said switching device and latching the combination of said NPN and PNP transistors into conduction for providing a relatively low impedance current path between said first and fourth terminals;

said switching device being operative from its turned-on condition to a turned-off condition via the application of a positive polarity control signal to said third terminal for turning-on said N channel field-effect transistor, which substantially lowers the relative impedance between its drain and source electrodes, thereby shunting current away from the emitter electrode of said PNP transistor to the collector electrode of said NPN transistor, substantially turning-off said PNP transistor and unlatching said switching device, permitting a zero volt or negative polarity control signal to be applied to said second terminal for turning-off said NPN transistor, completing the turn-off cycle for said device.

12. An integrated circuit semiconductor switching device characterised in that it includes merged equivalent NPN (91), and PNP (89) transistors, and comprises:

a substrate (95) of N-conductivity providing both a base region for said PNP transistor, and a collector region for said NPN transistor, said substrate having a top and a bottom face;

a first region (99) of P-conductivity wholly within and extending into the bottom face of said substrate, said first region providing both a collector region for said PNP transistor, and a base region for said NPN transistor;

a plurality of individual second regions (101) of N+ conductivity extending into the bottom face of said substrate, each wholly within said first region, each providing an emitter region for said NPN transistor;

first electrically conductive means (113) overlying the bottom face of said substrate upon portion of said first region for providing a first control electrode for said device;

second electrically conductive means (111) overlying the bottom face of said substrate upon portions of said plurality of second regions, for providing a cathode electrode for said device for receiving a source of reference potential;

a plurality of individual third regions (97) of P conductivity wholly within and extending into the top face of said substrate, said third regions each providing an emitter region for said PNP transistor;

third electrically conductive means (109) overlying the top face of said substrate upon portions of said individual third regions, for providing an anode electrode for said device for receiving an operating voltage;

said switching device being responsive to the application of a positive polarity control signal to said first control electrode, for turning-on said NPN and PNP equivalent transistors into a latched condition in the manner of a silicon-controlled-rectifier, for providing a relatively low impedance current path between said anode and cathode electrodes, whereby said device cannot be turned-off from this latched condition via a change in the level or polarity of signaling at its first control electrode; and

means responsive to a positive polarity control signal for providing a low impedance current path between said anode electrode and said substrate, thereby substantially reducing the current gain of said equivalent PNP transistor, unlatching the combination of said NPN and PNP transistors, thereby permitting said device to respond to either one of a zero volt or negative polarity control signal applied to its first control electrode, for turning-off said equivalent NPN transistor, thereby turning-off said switching device.

13. A switching device according to claim 12, characterised in that said means responsive to a positive polarity control signal includes:

a plurality of individual fourth regions (103) of N+ conductivity wholly within and extending into said plurality of third regions;

a plurality of first electrically insulative thin film coatings (105) individually overlying the top of said substrate at least between the nearest boundaries of said fourth regions in every juxtaposed pair;

a plurality of second electrically insulative thin film coatings (109) overlying the top of said substrate between each juxtaposed pair of third regions, said coatings extending to the nearest boundary of a fourth region in each one of said third regions;

a plurality of electrically conductive means (107) overlying each one of said plurality of first thin film coatings said plurality of electrically conductive means being electrically connected in common for forming a gate electrode for receiving a control signal;

so that the above-said combinations of elements provide an interdigitated N channel enhancement type of field-effect transistors, said substrate being a common source region for said field-effect transistors, said third regions providing channels, and said fourth regions providing drain regions;

whereby when a positive polarity control signal is applied to said gate electrode, during operation of said device as a silicon-controlled-rectifier, minority carriers are drawn into the areas of the third regions adjacent said insulative coatings, inducing a channel of relatively low impedance, permitting current to flow between said fourth regions and said substrate, thereby substantially reducing the current gain of said equivalent PNP transistor.

14. An integrated circuit switching device selectively operable in the manner of either a silicon-controlled-rectifier (SCR) or a bipolar transistor at any given time, characterised in that it comprises:

first (81) and second (83) output terminals;

base (87) and gate (85) terminals;

a semiconductor substrate (95) of a first conductivity type having a top and a bottom face;

a first region (99) of a second conductivity type extending into said bottom face;

a second region (101) of said first conductivity type at least partly overlying and contiguous with said first region within said substrate;

first to fourth successively juxtaposed third regions (97) of said second conductivity type extending into said top face of said substrate above said second region;

a plurality of fourth regions (103) of said first conductivity type, one of each extending from the top face of said substrate wholly into said first and fourth ones of third regions, respectively, two of said fourth regions extending from the top face of said substrate wholly into each one of said second and third ones of said third regions;

a plurality of electrically insulative thin film coatings (105) individually overlying the top face of said substrate between the opposing outer boundaries of said third and fourth regions;

first electrically conductive means (107) overlying each one of said plurality of electrically insulative thin film coatings, respectively, said gate terminal being electrically connected to said first electrically conductive means;

second electrically conductive means (109) both overlying central portions of said second and third ones of said third regions, and electrically connected to said first terminal;

third electrically conductive means (109) both overlying portions of the top face of said substrate between said third regions, and electrically connected to said base terminal;

said device in one mode of operation being responsive to a first control signal at its base terminal for turning on in the manner of an SCR, substantially reducing the impedance between said first and second output terminals, thereafter responsive to the level of a second control signal at its gate terminal for within a range setting the holding current for said device when operating as an SCR, said device also being responsive to the level of said second control signal exceeding a given level, for operating in the manner of a bipolar transistor, having high dv/dt, and permitting said device to be turned quickly off (relatively low to or turn-off time) via the application of a third control signal to its base terminal.

15.    An integrated circuit switching device according to claim 11, characterised in that said first region further consists of interdigitated regions (111, 113) extending from said bottom face of said substrate into and surrounded by said second region.

1/5

0065346

PRIOR ART

*Fig. 1.*

PRIOR ART

*Fig. 2.*

PRIOR ART

*Fig. 3.*

PRIOR ART

*Fig. 4.*

PRIOR ART

*Fig. 6.*

PRIOR ART

*Fig. 8.*

2/5    0065346

PRIOR ART    _Fig._5_

PRIOR ART    _Fig._7_

PRIOR ART    _Fig._9_

_Fig._10_

_Fig._11_

*Fig. 12.*

*Fig. 13.*

*Fig. 15.*

*Fig. 14.*

0065346

*Fig_16*

*Fig_17*

*Fig_19*

*Fig_18*

_Fig_.20_

_Fig_.21_